# EUROPEAN PATENT SPECIFICATION

(11) **EP 2 192 006 B1**
(45) Date of publication and mention of the grant of the patent: **26.07.2017**
(21) Application number: 09177176.6
(22) Date of filing: 26.11.2009
(51) Int. Cl.: B60R 16/023

(54) **Junction box for a vehicle**
Verteilergehäuse für ein Fahrzeug
Boîte de raccordement pour véhicule

(30) Priority: 27.11.2008 KR 20080119210
(43) Date of publication of application: 02.06.2010
(73) Proprietor: TYCO ELECTRONICS AMP KOREA Co., Ltd., Gyeongsangbuk-do, 38459 (KR)
(72) Inventor: Ho, Lee Joon, Suwon, Kyeonggi-DO (KR); Kyu, Lee Jong, Kyungsangbuk-Do (KR)
(74) Representative: Johnstone, Douglas Ian

(56) References cited:
- EP-A2- 0 700 133
- EP-A2- 1 179 453
- EP-A2- 1 209 036
- US-A- 5 011 417
- US-A1- 2003 030 996

## Description

The present invention relates to a one board type box, to which an electronic module performing not only a power distribution function but also additional control and communication functions is connected, and more particularly to a junction box for a vehicle, in which connectors are disposed on both surfaces of one board so as to perform control and communication functions while assuring an After-Service or After-Sales Service (A/S) region of fuses and to reduce a used space on the board.

In general, vehicles, called as aggregates to which high electronic techniques are applied, comprise a large number of electronic parts, and new electronic techniques are now being additionally applied to vehicles. To reflect this trend, the respective electronic parts exert their original functions under the condition that power is supplied to the electronic parts, and thus require many wires for power supply.

Conventionally, a fuse box was used to protect a large number of wires, and the wires in the fuse box were closely disposed to supply power to respective electronic parts.

However, the fuse box caused many problems due to mis-assembly during an assembly process and compact disposition of terminals. In order to make up for these problems of the fuse box, a junction box has been manufactured by replacing wires in the fuse box with a printed circuit board and metal layers and connecting the fuse box and the wires by input and output connectors.

Further, as functions of vehicles have been increased now, electronic systems are becoming increasingly complicated. Moreover, electric modules in vehicles are increased. Therefore, in addition to the existing power distribution function using relays/fuses, the junction box must serve as an electronic module having additional control and communication functions.

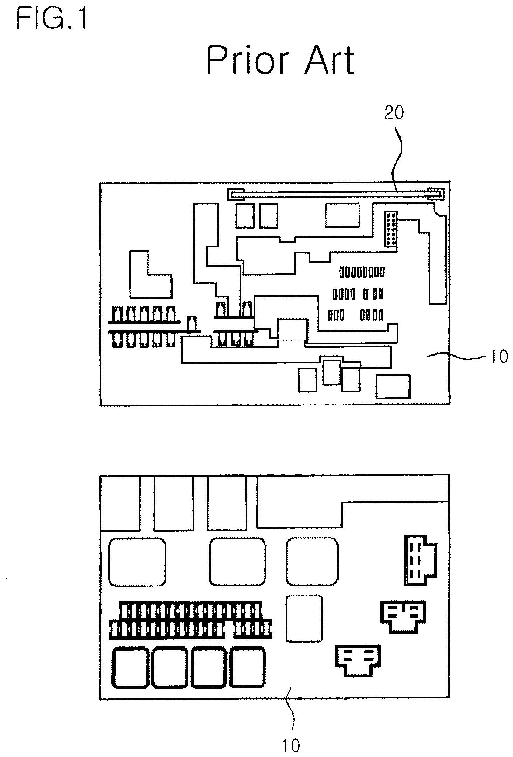

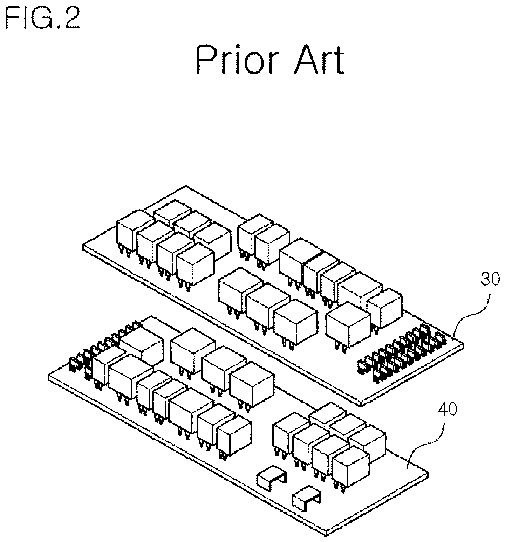

Hereinafter, conventional junction boxes will be described with reference to the annexed drawings wherein FIGs. 1 and 2 are views illustrating conventional junction boxes.

As shown in FIG. 1, a conventional junction box includes a main board 10, on which fuses and relays are mounted, provided with a daughter board 20 performing a control function. That is, such a junction box is manufactured by connecting the two boards 10 and 20. Here, the daughter board 20 is mounted on the upper surface of the main board 10, as shown in FIG. 1, and connection between the two boards 10 and 20 is carried out using connectors.

Further, two boards may be independently manufactured. That is, as shown in FIG. 2, another conventional junction box includes a first board 30, on which fuses and relays are mounted, and a second board 40 performing a control function. Here, connection between the first board 30 and the second board 40 is carried out using jumper pins.

In order to add the control function to the power distribution function through the fuses and relays, the above conventional junction boxes respectively require additional boards, as shown in FIGs. 1 and 2, because it is difficult to accommodate electronic parts to perform the control function within a limited board size. However, when the two boards are used, manufacturing costs of the junction boxes are raised. Moreover, size and weight of the junction boxes are increased, thus generating increase in the overall volume and weight of a vehicle. Further, installation of connectors to connect the junction boxes to external terminals is hampered by many restrictions.

EP 0700133 A discloses an electrical connection box comprising an insulation plate having an upper surface and a lower surface. Each surface has pairs of projections formed in a wiring pattern and a wire is inserted between the pairs of projections to form the required shape of wiring. The insulation plate is mounted in a casing consisting of upper and lower casing parts. A connector is mounted in a receptacle on the outside of the upper casing part and another connector is mounted in a receptacle on the outside of the lower casing part. Each connector is connected to the wire on the corresponding side of the casing via a cramping terminal. A fuse or a relay can be connected to a said wire via an intermediate terminal between the terminal of the fuse or relay and the cramping terminal.

The present invention has been made in view of the above problems, and it is an object of the present invention to provide a junction box, in which fuses, relays, and a control and communication unit are mounted on both surfaces of a printed circuit board (PCB), and connectors to connect the fuses, the relays, and the control and communication unit to the outside are also mounted on both surfaces of the PCB, thereby reducing manufacturing costs of the board, having reduced size and weight, and effectively performing electrical connection with the outside.

In accordance with the present invention, the above and other objects can be accomplished by the provision of a junction box comprising: at least one fuse; at least one relay; a first connector unit; a second connector unit; and a cover unit arranged to at least partially expose the at least one fuse, the first connector unit, and the second connector unit, characterized in that the junction box includes a PCB unit comprising a PCB board provided with first and second surfaces, and a control and communication unit comprising a first control and communication unit and a second control and communication unit; the least one fuse, the first connector unit, and the first control and communication unit are mounted on the first surface of the PCB board; the at least one relay, the second connector unit, and the second control and communication unit are mounted on the second surface of the PCB board; and the cover unit covers the PCB unit.

The cover unit may include a first cover covering the first or upper surface of the PCB board so as to expose the fuses and the first connector unit, a second cover covering the second or lower surface of the PCB board so as to expose the second connector unit, and a shielding part to shield a region of the lower cover to expose the second connector unit.

The upper cover may include an upper cover body, fuse exposing grooves provided on the upper cover body to expose the fuses, and first connector exposing grooves provided on the upper cover body to expose the first connector unit, and the lower cover may include a lower cover body, and second connector exposing grooves provided on the lower cover body to expose the second connector unit.

The fuses may be disposed at one side of the left and right sides of the center of the PCB board, and the first connector unit and the first control and communication unit may be disposed at the other side.

The above and other objects, features and other advantages of the present invention will be more clearly understood from the following detailed description taken in conjunction with the accompanying drawings, in which:
FIGs. 1 and 2 are views illustrating conventional junction boxes;
FIG. 3 is an exploded perspective view of a junction box in accordance with the present invention;
FIG. 4 is a view illustrating front and rear surfaces of the junction box in accordance with the present invention;
FIG. 5 is a front view of a PCB unit in accordance with the present invention; and
FIG. 6 is a rear view of the PCB unit in accordance with the present invention.

Hereinafter, preferred embodiments of the present invention will be described in detail with reference to the annexed drawings.

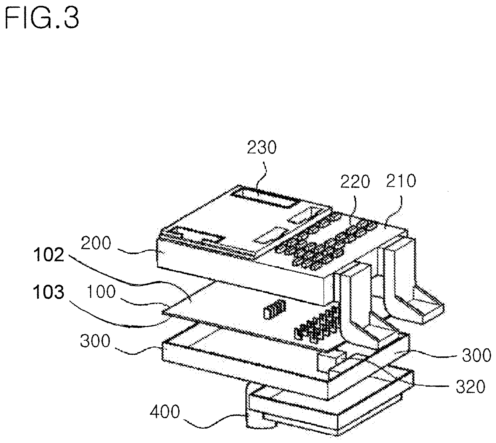

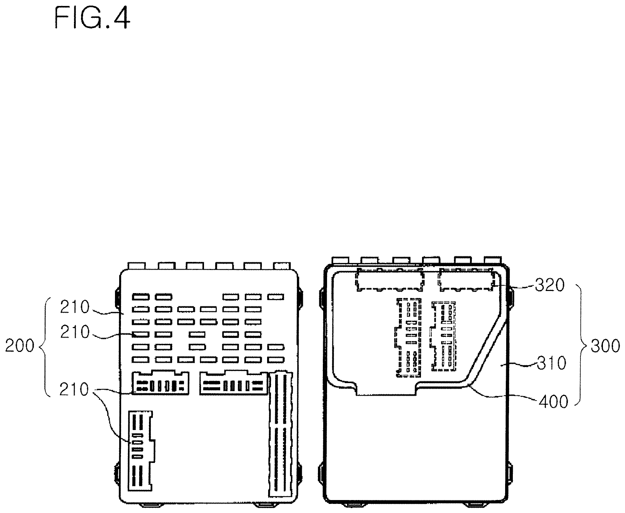

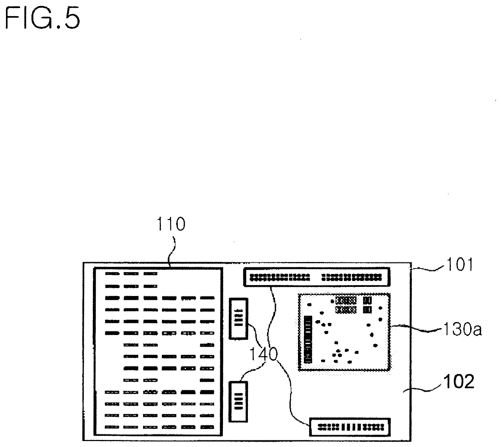

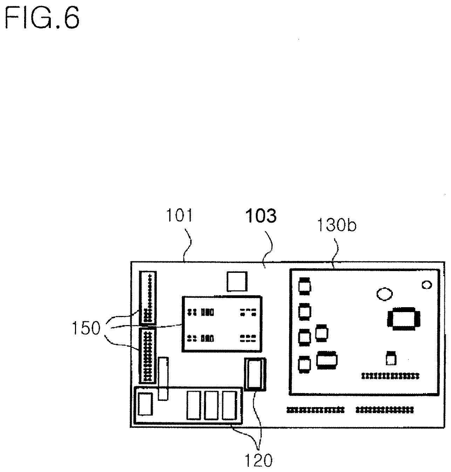

As shown in FIGs. 3 and 4, the junction box in accordance with the present invention includes a PCB unit 100 provided with upper or first and lower or second surfaces 102, 103, on which fuses 110, relays 120, a control and communication unit 130, and connector units 140 and 150 are mounted (see FIGs. 5 and 6). An upper or first cover 200 covers the upper surface 102 of the PCB unit 100 and exposes the fuses 110 and the first connector unit 140. A lower or second cover 300 covers the lower surface 103 of the PCB unit 100 and exposes the second connector unit 150. A shielding part 400 shields a region of the lower cover 300 which exposes the second connector unit 150.

As described above, the above junction box includes the PCB unit 100 and the cover units to cover the PCB unit 100. Further, the PCB unit 100 of the junction box is electrically connected to external electronic modules by the first and second connector units 140 and 150. Moreover, the PCB unit 100 of the junction box receives power supplied from the outside, and then distributes the power.

Here, the junction box is characterized in that the connector units 140 and 150 are disposed on the upper and lower surfaces 102,103 of one board (i.e. a PCB) and the fuses 110, the relays 120, and the control and communication unit 130 are effectively disposed, and thus eliminates use of any additional board (see FIGs. 5 and 6). Further, the fuses 110 are disposed on the upper surface 102 of the PCB unit 100, and thus A/S (e.g. repair/replacement) on the fuses 110 is freely performed.

In the present invention, the PCB unit 100 is covered with the upper cover 200 and the lower cover 300, and thus is protected from external impact.

As shown in FIGs. 3 and 4, the upper cover 200 includes an upper or first cover body 210, and fuse exposing grooves or apertures 220 and first connector exposing grooves or apertures 230 provided on the upper cover body 210.

The upper cover body 210 is formed in the shape of a rectangular box having an opened lower portion. The upper cover body 210 is made of an insulating material, such as plastic or rubber, and thus protects the PCB unit 100 from external physical and electrical impacts.

Further, the fuse exposing grooves 220 to expose a plurality of the fuses 110 mounted on the upper surface 102 of the PCB unit 100 are provided on the upper cover body 210. Here, the fuse exposing grooves 220 are formed at positions corresponding to the plurality of the fuses 110. The fuses 110 on the PCB unit 100 are exposed to the outside of the upper cover body 210 through the fuse exposing grooves 220. Thereby, the fuses 110 may be easily replaced with new ones. Further, the fuses 110 may be partially exposed to the outside of the upper cover body 210 through the fuse exposing grooves 220. Thus, although the upper cover body 210 is not separated from the PCB unit 100, it is possible to check, from the outside, whether or not the fuses 110 are damaged. Of course, the fuse exposing grooves 220 may be omitted, as occasion demands.

Further, the first connector exposing grooves 230 to expose the first connector unit 140 mounted on the upper surface 102 of the PCB unit 100 are provided on the upper cover body 210. Connector jacks (or sockets) electrically connected with the first connector unit 140 are inserted into the first connector exposing grooves 230. The first connector unit 140 is electrically connected to the outside through the connector jacks inserted into the first connector exposing grooves 230. Here, the overall regions or only pin regions of the first connector unit 140 may be exposed through the first connector exposing grooves 230.

The lower cover 300 corresponding to the above-described the upper cover 200 includes a lower or second cover body 310 and second connector exposing grooves or apertures 320. Preferably, the lower cover body 310 is made of the same material as the upper cover body 210. A receipt space is formed by connecting the upper cover body 210 and the lower cover body 310, and the PCB unit 100 is located within the receipt space. The second connector exposing grooves 320 to expose the second connector unit 150 mounted on the lower surface of the PCB unit 100 are provided on the lower cover body 310. Connector jacks electrically connected with the second connector unit 150 are inserted into the second connector exposing grooves 320. The second connector unit 150 is electrically connected to the outside through the connector jacks inserted into the second connector exposing grooves 320. In the same manner as the first connector exposing grooves 230, the overall regions or only pin regions of the second connector unit 150 may be exposed through the second connector exposing grooves 320.

The shielding part 400 to shield the second connector exposing grooves 320 is mounted on the lower cover 300 at the second connector exposing grooves 320. The shielding part 400 is formed in the shape of a hollow box having an opened upper portion, and a cable box, through which cables pass, and a groove are formed on the upper surface of the shielding part 400. The shielding part 400 shields the second connector exposing grooves 320 of the lower cover 300, thereby preventing the second connector exposing grooves 320 from being exposed directly to the outside. Further, the shielding part 400 prevents the second connector unit 150 exposed to the outside through the second connector exposing grooves 320 from being contaminated, and prevents external connection jacks (or plus or sockets) from being easily separated from the second connector unit 150 of the PCB unit 100.

The fuses 110, the relays 120, and the control and communication unit 130 are integrally mounted on the PCB unit 100, which is surrounded by the upper cover 200 and the lower cover 300, thereby reducing size of the junction box as well as reducing manufacturing costs of the junction box. Further, the first connector unit 140 and the second connector unit 150 are provided on the upper surface and the lower surface 102,103 of the PCB unit 100, thereby facilitating electrical connection with the outside.

Hereinafter, the PCB unit in accordance with the present invention will be described in detail with reference to FIGs. 5 and 6.

As shown in FIGs. 5 and 6, the PCB unit 100 in accordance with the present invention includes a PCB board or a printed circuit (PC) board 101, a plurality of the fuses 110 mounted on the upper surface 102 of the PCB board 101, a plurality of the relays 120 mounted on the lower surface 103 of the PCB board 101, the control and communication unit 130 (130a and 130b) provided on the upper and lower surfaces 102, 103 of the PCB board 101, the first connector unit 140 provided on the upper surface 102 of the PCB board 101, and the second connector unit 150 provided on the lower surface 103 of the PCB board 101.

As described above, the junction box in accordance with the present invention includes elements having a power distribution function and elements having control and communication functions, which are integrated onto one board, thereby reducing manufacturing costs and the number of parts and having reduced size and weight.

A multilayer board having wire patterns formed on the inside and outer surface thereof is used as the PCB board 101.

As shown in FIG. 5, the plural fuses 110 are mounted on the upper surface 102 of the PCB board 101 at one side. Preferably, 2-terminal fuses may be used as the fuses 110. Size and standard of the fuses 110 are not limited, and various fuses to distribute power of a vehicle may be used as the fuses 100. Therefore, a mounted part, on which the fuses 110 are mounted, is provided on the PCB board 101. Here, the fuses 110 are preferably concentrated upon one side (the left side of FIG. 5) of the center of the PCB board 101. Thereby, other parts may be mounted at the other side (the right side of FIG. 5). That is, the fuses 110 are disposed at the left side of the center of the PCB board 101, and the first connector unit 140 and a first control and communication unit 130a are disposed at the right side of the center of the PCB board 101. Here, the center of the PCB board 101 refers to the central line of the PCB board 101.

As described above, the fuses 110 are mounted on the upper surface 102 of the PCB board 101, and thus A/S on the fuses 110 may be easily performed.

Further, the plural relays 120 are mounted on the lower surface 103 of the PCB board 101. Here, the relays 120 may be mounted on the upper surface 102 of the PCB board 101. Further, size and standard of the relays 120 are not limited, and various kinds of relay may be used as the relays 120, as occasion demands.

The junction box in accordance with the present invention includes the control and communication unit 130 having a control function and a communication function of electronic modules.

The control and communication unit 130 is divided into first and second control and communication units 130a and 130b, which are respectively mounted on the upper and lower surfaces 102, 103 of the PCB board 101. If parts (i.e. chips or circuit elements) forming the control and communication unit 130 are formed on one surface, the parts occupy the overall regions of the surface. Therefore, respective elements of the control and communication unit 130 are divided into two units. That is, as shown in FIGs. 5 and 6, the first control and communication unit 130a is mounted on the upper surface 102 of the PCB board 101, and the second control and communication unit 130b is mounted on the lower surface 103 of the PCB board 101. Thereby, only a part of each of the upper and lower surfaces 102, 103 of the PCB board 101 is used to mount the control and communication unit 130, and thus occupation of the overall regions of one surface of the PCB board 101 by the control and communication unit 130 is unnecessary. Further, the first control and communication unit 130a is mounted on the upper surface 102 of the PCB board 101 at a region where the fuses 110 are not mounted, thereby being capable of suppressing interference of the first control and communication unit 130a with the fuses 110. Further, the second control and communication unit 130b is mounted on the lower surface 103 of the PCB board 101 at a region corresponding to the first control and communication unit 130a, thereby being capable of facilitating electrical connection between the first control and communication unit 130a and the second control and communication unit 130b. Of course, the second control and communication unit 130b may be mounted on the lower surface 103 of the PCB board 101 at a region corresponding to the fuses 110, thereby being capable of suppressing interference of the second control and communication unit 130b with the fuses 110.

Further, the first and second connector units 140 and 150 to apply power or an electrical signal to the fuses 110, the relays 120, and the control and communication unit 130 mounted on the PCB board 101 or to transmit power or an electrical signal to the outside are mounted on the PCB board 101.

The first connector unit 140 is formed on the upper surface 102 of the PCB board 101 at a region where the fuses 110 and the first control and communication unit 130a are not mounted, and the first connector unit 140 includes four connectors, as shown in FIG. 5. Further, the second connector unit 150 is formed on the lower surface 103 of the PCB board 101 at a region where the second control and communication unit 130b and the relays 120 are not mounted. Two connectors of the first connector unit 140 are located at the central region of the PCB board 101, and the remaining two connectors are located at the edge of the PCB board 101. That is, the four connectors are disposed in a C shape.

The second connector unit 150 includes three connectors, as shown in FIG. 6. Each of the respective connectors is provided with a pin protruded to the outside of the PCB board 101. These connector pins are electrically connected to the fuses 110, the relays 120, and the control and communication unit 130 through wires within the PCB board 101. Two connectors of the second connector unit 150 are located at the edge of the PCB board 101, and the remaining one connector is located at the central region of the PCB board 101. That is, the three connectors are disposed in a T shape.

As described above, the junction box in accordance with the present invention includes the first and second connector units 140 and 150, which are respectively disposed on the upper and lower surfaces 102,103 of the PCB board 101, thereby facilitating electrical connection of the fuses 110, the relays 120, and the control and communication unit 130 mounted on the PCB board 101 with electronic modules of a vehicle. This is achieved by adjusting disposition of the fuses 110, the relays 120, and the control and communication unit 130 on the PCB board 101, as shown in FIGs. 5 and 6.

As apparent from the above description, the present invention provides a junction box, in which fuses, relays, and a control and communication unit are mounted on a single board, thereby reducing manufacturing costs of the board, reducing size and weight of the board, and effectively performing communication with external electronic modules.

Although the preferred embodiments of the present invention have been disclosed for illustrative purposes, those skilled in the art will appreciate that various modifications, additions and substitutions are possible, without departing from the scope of the invention as disclosed in the accompanying claims.

## Claims

1. A junction box comprising:
at least one fuse (110); at least one relay (120); a first connector unit (140); a second connector unit (150); and a cover unit (200,300) arranged to at least partially expose the at least one fuse (110), the first connector unit (140), and the second connector unit (150), **characterized in that**
the junction box includes a PCB unit (100) comprising a PCB board (101) provided with first and second surfaces (102, 103), and
a control and communication unit (130) comprising a first control and communication unit (130a) and a second control and communication unit (130b);
the least one fuse (110), the first connector unit (140), and the first control and communication unit (130a) are mounted on the first surface (102) of the PCB board (101);
the at least one relay (120), the second connector unit (150), and the second control and communication unit (130b) are mounted on the second surface (103) of the PCB board (101); and
the cover unit (200,300) covers the PCB unit (100).

2. The junction box according to claim 1, wherein the cover unit includes:
a first cover (200) covering the first surface (102) of the PCB board (101) and arranged to at least partially expose the at least one fuse (110) and the first connector unit (140); and
a second cover (300) covering the second surface (103) of the PCB board (101) and arranged to at least partially expose the second connector unit (150).

3. The junction box according to claim 2, wherein the cover unit includes a shielding part (400) to shield a region of the second cover (300) that is arranged to at least partially expose the second connector unit (150).

4. The junction box according to claim 2 or 3, wherein:
the first cover (200) includes a first cover body (210), at least one fuse exposing aperture (220) provided on the first cover body (210) to at least partially expose the at least one fuse (110), and at least one first connector exposing aperture (230) provided on the first cover body (210) to at least partially expose the first connector unit (140); and
the second cover (300) includes a second cover body (310), and at least one second connector exposing aperture (320) provided on the second cover body (310) to at least partially expose the second connector unit (150).

5. The junction box according to any preceding claim, wherein the first and second surfaces (102,103) are substantially opposite surfaces of the PCB board (101).

6. The junction box according to any preceding claim, wherein the at least one fuse (110) is disposed to one side of the center of the PCB board (101), and the first connector unit (140) and the first control and communication unit (130a) are disposed to the opposite side of the center of the PCB board (101).

7. The junction box according to any preceding claim, wherein the cover unit (200,300) is arranged to completely expose the at least one fuse (110), the first connector unit (140), and the second connector unit (150).

## Patentansprüche

1. Verteilergehäuse, das Folgendes umfasst:
wenigstens eine Sicherung (110); wenigstens ein Relais (120); eine erste Verbindereinheit (140); eine zweite Verbindereinheit (150); und eine Deckeleinheit (200, 300), so ausgelegt, dass sie die wenigstens eine Sicherung (110), die erste Verbindereinheit (140) und die zweite Verbindereinheit (150) wenigstens teilweise exponiert, **dadurch gekennzeichnet, dass**
das Verteilergehäuse eine Leiterplatteneinheit (100) beinhaltet, die eine Leiterplatte (101) mit einer ersten und einer zweiten Fläche (102, 103) umfasst, und
eine Steuer- und Kommunikationseinheit (130), die eine erste Steuer- und Kommunikationseinheit (130a) und eine zweite Steuer- und Kommunikationseinheit (130b) umfasst;
die wenigstens eine Sicherung (110), die erste Verbindereinheit (140) und die erste Steuer- und Kommunikationseinheit (130a) auf der ersten Fläche (102) der Leiterplatte (101) montiert sind;
das wenigstens eine Relais (120), die zweite Verbindereinheit (150) und die zweite Steuer- und Kommunikationseinheit (130b) auf der zweiten Fläche (103) der Leiterplatte (101) montiert sind; und
die Deckeleinheit (200, 300) die Leiterplatteneinheit (100) bedeckt.

2. Verteilergehäuse nach Anspruch 1, wobei die Deckeleinheit Folgendes beinhaltet:
einen ersten Deckel (200), der die erste Fläche (102) der Leiterplatte (101) bedeckt und so ausgelegt ist, dass er die wenigstens eine Sicherung (110) und die erste Verbindereinheit (140) wenigstens teilweise exponiert; und
einen zweiten Deckel (300), der die zweite Fläche (103) der Leiterplatte (101) bedeckt und so ausgelegt ist, dass er die zweite Verbindereinheit (150) wenigstens teilweise exponiert.

3. Verteilergehäuse nach Anspruch 2, wobei die Deckeleinheit einen Abschirmungsteil (400) zum Abschirmen einer Region des zweiten Deckels (300) aufweist, so ausgelegt, dass er die zweite Verbindereinheit (150) wenigstens teilweise exponiert.

4. Verteilergehäuse nach Anspruch 2 oder 3, wobei:
der erste Deckel (200) einen ersten Deckelkörper (210), wenigstens eine Sicherungsexpositionsöffnung (220), die an dem ersten Deckelkörper (210) vorgesehen ist, um die wenigstens eine Sicherung (110) wenigstens teilweise zu exponieren, und wenigstens eine erste Verbinderexpositionsöffnung (230) aufweist, die an dem ersten Deckelkörper (210) vorgesehen ist, um die erste Verbindereinheit (140) wenigstens teilweise zu exponieren; und
der zweite Deckel (300) einen zweiten Deckelkörper (310) und wenigstens eine zweite Verbinderexpositionsöffnung (320) aufweist, die an dem zweiten Deckelkörper (310) vorgesehen ist, um die zweite Verbindereinheit (150) wenigstens teilweise zu exponieren.

5. Verteilergehäuse nach einem vorherigen Anspruch, wobei die erste und die zweite Fläche (102, 103) im Wesentlichen gegenüberliegende Flächen der Leiterplatte (101) sind.

6. Verteilergehäuse nach einem vorherigen Anspruch, wobei die wenigstens eine Sicherung (110) auf einer Seite der Mitte der Leiterplatte (101) angeordnet ist und die erste Verbindereinheit (140) und die erste Steuer- und Kommunikationseinheit (130a) auf der gegenüberliegenden Seite der Mitte der Leiterplatte (101) angeordnet sind.

7. Verteilergehäuse nach einem vorherigen Anspruch, wobei die Deckeleinheit (200, 300) so ausgelegt ist, dass sie die wenigstens eine Sicherung (110), die erste Verbindereinheit (140) und die zweite Verbindereinheit (150) völlig exponiert.

## Revendications

1. Boîte de raccordement comprenant :
au moins un fusible (110) ; au moins un relais (120) ; une première unité de connecteurs (140) ; une seconde unité de connecteurs (150) ; et une unité de couvercle (200, 300) agencée pour exposer au moins partiellement l'au moins un fusible (110), la première unité de connecteurs (140) et la seconde unité de connecteurs (150), **caractérisée en ce que**
la boîte de raccordement comporte une unité de carte à circuit imprimé (100) comprenant une carte à circuit imprimé (101) présentant des première et seconde surfaces (102, 103), et
une unité de commande et de communication (130) comprenant une première unité de commande et de communication (130a) et une seconde unité de commande et de communication (130b) ;
l'au moins un fusible (110), la première unité de connecteurs (140) et la première unité de commande et de communication (130a) sont montés sur la première surface (102) de la carte à circuit imprimé (101) ;
l'au moins un relais (120), la seconde unité de connecteurs (150) et la seconde unité de commande et de communication (130b) sont montés sur la seconde surface (103) de la carte à circuit imprimé (101) ; et
l'unité de couvercle (200, 300) recouvre l'unité de carte à circuit imprimé (100).

2. Boîte de raccordement selon la revendication 1, dans laquelle l'unité de couvercle comporte :
un premier couvercle (200) recouvrant la première surface (102) de la carte à circuit imprimé (101) et agencé pour exposer au moins partiellement l'au moins un fusible (110) et la première unité de connecteurs (140) ; et
un second couvercle (300) recouvrant la seconde surface (103) de la carte à circuit imprimé (101) et agencé pour exposer au moins partiellement la seconde unité de connecteurs (150).

3. Boîte de raccordement selon la revendication 2, dans laquelle l'unité de couvercle comporte une partie de blindage (400) pour blinder une région du second couvercle (300) qui est agencé pour exposer au moins partiellement la seconde unité de connecteurs (150).

4. Boîte de raccordement selon la revendication 2 ou 3, dans laquelle :
le premier couvercle (200) comporte un premier corps de couvercle (210), au moins une ouverture d'exposition de fusible (220) fournie sur le premier corps de couvercle (210) pour exposer au moins partiellement l'au moins un fusible (110), et au moins une première ouverture d'exposition de connecteur (230) fournie sur le premier corps de couvercle (210) pour exposer au moins partiellement la première unité de connecteurs (140) ; et
le second couvercle (300) comporte un second corps de couvercle (310), et au moins une seconde ouverture d'exposition de connecteur (320) fournie sur le second corps de couvercle (310) pour exposer au moins partiellement la seconde unité de connecteurs (150).

5. Boîte de raccordement selon l'une quelconque des revendications précédentes, dans laquelle les première et seconde surfaces (102, 103) sont des surfaces sensiblement opposées de la carte à circuit imprimé (101).

6. Boîte de raccordement selon l'une quelconque des revendications précédentes, dans laquelle l'au moins un fusible (110) est disposé sur un côté du centre de la carte à circuit imprimé (101), et la première unité de connecteurs (140) et la première unité de commande et de communication (130a) sont disposées sur le côté opposé du centre de la carte à circuit imprimé (101).

7. Boîte de raccordement selon l'une quelconque des revendications précédentes, dans laquelle l'unité de couvercle (200, 300) est agencée pour exposer complètement l'au moins un fusible (110), la première unité de connecteurs (140), et la seconde unité de connecteurs (150) .
